# EUROPEAN PATENT APPLICATION

(11) **EP 1 675 269 A1**
(43) Date of publication of application: **28.06.2006**
(21) Application number: 05026857.2
(22) Date of filing: 08.12.2005
(51) Int. Cl.: H03M 11/20, G06F 3/023

(54) **Serial interface to control sequential scanning of the lines of a keyboard matrix**

(30) Priority: 22.12.2004 KR 2004110662
(71) Applicant: LG Electronics Inc., Yongdungpo-Gu Seoul (KR)
(72) Inventor: Kim, Jae-Chol, Seongbuk-Gu Seoul (KR)
(74) Representative: Katérle, Axel

(57) **Abstract**

An apparatus and method for controlling keys of a mobile terminal are disclosed. An interface chip for performing conversion between parallel data and serial data is provided between a controller and a key input unit. The serial data is converted into parallel data through the interface chip and outputted to the key input unit, and the parallel data of the key input unit is converted into serial data through the interface chip and transmitted to the controller. Thus, the key input unit having a large number of keys can be controlled by using with a small number of controller pins, and thus, it is easy to design a mobile terminal.

## Description

### BACKGROUND OF THE INVENTION

### 1. Field of the Invention

The present invention relates to an apparatus and method for controlling keys of a mobile terminal.

### 2. Description of the Related Art

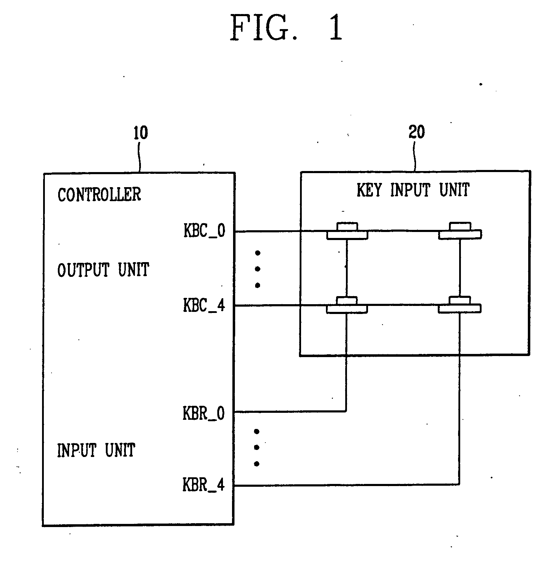

Figure 1 illustrates the construction of a general apparatus for controlling keys of a mobile terminal.

As shown in Figure 1, a general key controlling apparatus of a mobile terminal includes: a controller 10 having an output unit with a certain number of output pins (KBC_0-KBC_4) for outputting a signal and an input unit with a certain number of input pins (KBR_0-KBR_4) for receiving the signal according to key inputting; and a key input unit 20 for connecting the output unit and the input unit according to key inputting manipulation by a user.

The key input unit 20 includes the output pins and the input pins arranged in a matrix form and switches for connecting each output pin and each input pin. One switch serves as one key.

The key controlling apparatus of a mobile terminal constructed as described above operates as follows.

If there is no input, each switch of the key input unit 20 does not connect each output pin and each input pin of the controller 10. The controller 10 outputs signals through the output pins (KBC_0-KBC_4) of the output unit, and the input pins (KBR_0-KBR_4) of the input unit maintain low level signals.

When a key is inputted from outside, namely, when a corresponding switch of the key input unit 20 is manipulated, a corresponding output pin of the output unit and a corresponding input pin of the input unit are connected and a signal of the output pin connected to the corresponding input pin is changed to a low level. When an interrupt is generated b the low level signal, the controller 10 checks the output pin with the low level signal.

In order to check the input pin connected to the checked output pin, the controller 10 searches the input pin which changes a signal of the output pin by changing a signal of each input pin of the input unit in turn. At this time, the controller 10 can check an inputted key by searching one of 25 combinations consisting of five input pins (KBR_0-KBR_4) and five output pins (KBC_0-KBC_4).

In the general key controlling apparatus of the of a mobile terminal, for example, if the number of keys is 25, the controller needs 10 pins (five input pins and five output pins) according to the 5x5 matrix structure in order to control 25 keys. However, generally, the number of keys of a key pad of a mobile terminal is limited, so using of the mobile terminal is consequently limited.

In order to meet the requirement of diverse services of users, the number of external input keys of the mobile terminal needs to be increased. In this respect, in the key controlling apparatus of the general mobile terminal, if the number of keys of the key input unit is increased, the number of pins of the controller is also increased. Namely, the mobile terminal includes a large number of input keys such as a key board of a computer, the number of pins required for the controller is more increased. For example, if 64 input keys are required, 16 pins are to be used for the controller according to a 8x8 matrix structure.

Thus, since the number of required input keys is increased, the number of pins of the controller is accordingly increased, too many pins are allocated to the controller to control input keys, making it difficult to enhance performance of the controller. In addition, easiness of designing of the pins of the controller for a different function is much degraded.

### SUMMARY OF THE INVENTION

Therefore, one object of the present invention is to provide an apparatus and method for controlling keys of a mobile terminal capable of removing restriction of using keys by increasing the number of keys of a key pad, and controlling a large number of keys by using a relatively small number of pins of a controller for controlling keys.

Another object of the present invention is to provide an apparatus and method for controlling external input keys by using the small number of pins by using a controller.

To achieve at least the above objects in whole or in parts, there is provided an apparatus for controlling keys of a mobile terminal including: an interface chip for performing conversion between parallel data and serial data and generating an interrupt when a key is inputted; a key input unit for connecting an output port and an input port of the interface chip in order to input a key inputted from a user to the interface chip; and a controller for recognizing the inputted key of the key input unit by using a certain number of address pins for accessing a register of the interface chip, a certain number of data pins for receiving and transmitting the serial data from and to the interface chip in a certain communication method, and an interrupt pin for receiving the interrupt.

To achieve at least these advantages in whole or in parts, there is further provided a method for controlling keys of a mobile terminal having a controller, an interface chip and a key input unit, including: a step in which when an interrupt is received from an interface chip to an interrupt pin of the controller, the controller senses key inputting of the key input unit; a step in which when the key inputting is sensed, the controller reads serial data from the interface chip through a serial communication data pin; a step in which the controller compares the read serial data with previously stored serial data and searches an input pin of the interface chip connected to the key; and a step in which the controller sequentially outputs a plurality of serial data sequence obtained by changing in turn data of each output pin of the interface chip, to the interface chip through the serial communication data pin in order to search an output pin of the interface chip connected to the key.

The method for controlling keys of a mobile terminal further includes: a step in which the controller outputs initialization serial data through the serial communication data pin and an address through an address pin to the interface hip; and a step in which the interface chip stores the initialization serial data as parallel data in a register region corresponding to the address and outputs the initialization parallel data to the key input unit through an output port.

Additional advantages, objects, and features of the invention will be set forth in part in the description which follows and in part will become apparent to those having ordinary skill in the art upon examination of the following or may be learned from practice of the invention. The objects and advantages of the invention may be realized and attained as particularly pointed out in the appended claims.

### BRIEF DESCRIPTION OF THE DRAWINGS

The invention will be described in detail with reference to the following drawings in which like reference numerals refer to like elements wherein:
Figure 1 illustrates the construction of an apparatus for controlling keys of a general mobile terminal;
Figure 2 illustrates the construction of an apparatus for controlling keys of a mobile terminal in accordance with a preferred embodiment of the present invention; and
Figure 3 illustrates a change of input parallel data of an input pin of an interface chip according to key inputting.

### DETAILED DESCRIPTION OF THE PREFERRED EMBODIMENTS

In the present invention, an interface chip for performing conversion between parallel data and serial data is provided between a controller and a key input unit of a mobile terminal, the serial data of the controller is converted into parallel data through the interface chip and outputted to the key input unit, and the parallel data of the key input unit is converted into serial data through the interface chip and transmitted to the controller, whereby the controller can control the key input unit having a large number of keys by using a small number of pins.

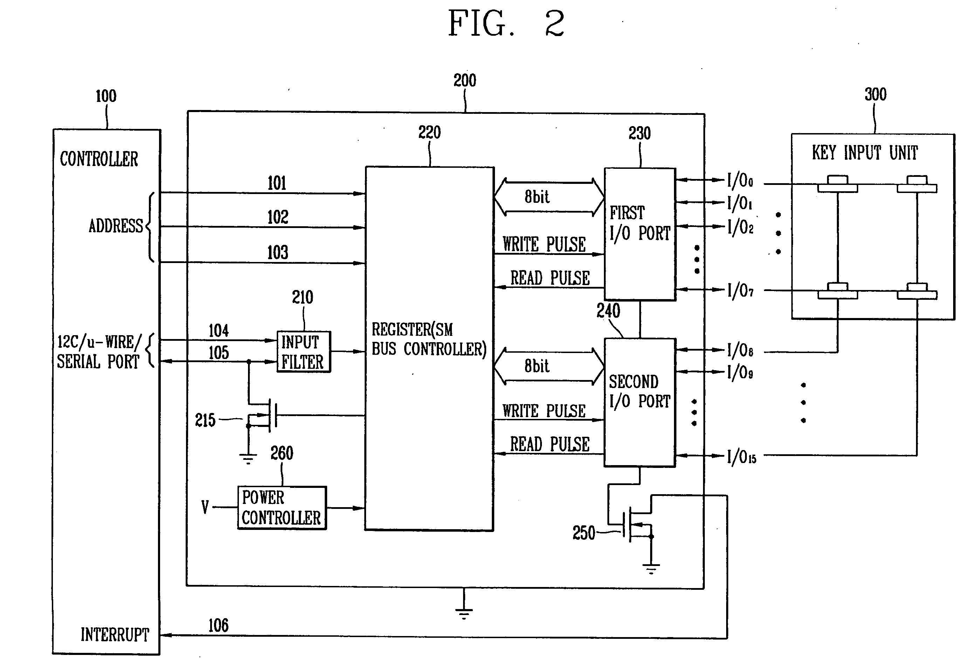

Figure 2 illustrates the construction of an apparatus for controlling keys of a mobile terminal in accordance with a preferred embodiment of the present invention.

The apparatus for controlling keys of a terminal includes: an interface chip 200 for performing conversion between parallel data and serial data and generating an interrupt when a key is inputted; a key input unit 300 for connecting an output port and an input port of the interface chip 200 when the key is inputted form a user, and transmitting the inputted key to the interface chip 200; and a controller 100 for recognizing the inputted key by using three pins 101-103 for address lines for accessing a register of the interface chip 200, two pins 104 and 105 for giving and receiving the serial data to and from the interface chip 200 through a certain communication method, and one pin 106 for receiving the interrupt.

The certain communication method includes an l2C (or IIC (Inter Integrated Circuit)) method, a micro-WIRE method and a general serial communication method.

The interface chip 200 includes: an input filter 210 for filtering serial data transmitted from the controller 100 according to the certain communication method; a register 220 for storing the serial data received from the input filter 210 as parallel data according to an address outputted from the controller 110 and converting the parallel data into serial data under the control of the controller 110; a first input/output port 230 for transmitting and receiving certain bit(s) of first parallel data to and from the register 220; a second input/output port 240 for transmitting and receiving certain bit(s) of second parallel data to and from the register 220; a first transistor 250 for generating an interrupt when a key inputted; a second transistor 215 for transmitting the serial data from the register 220 to the controller 100; and a power controller 260 for turning on/off power of the interface chip 200 or resetting the interface chip 200.

When the first input/output port 230 is set as an output port, the second input/output port 240 is set as an input port, and if the first input/output port 230 is set as an input port, the second input/output port 240 is set as an output port.

The key input unit 300 has a matrix form with a plurality of pins of the first input/output port 230 and a plurality of pins of the second input/output port 240.

The apparatus for controlling key of the mobile terminal constructed as described above operates as follows.

For example, the key input unit 300 includes 64 keys; the first and second input/output ports 230 and 240 include 8 pins, respectively.

First, the controller 100 outputs arbitrary serial data to the interface chip 200 through the serial ports 104 and 105 and a corresponding address for the serial data to be stored to the interface chip 200 through the address line pins 101-103. As the serial port, a 12C port, a micro-WIRE port or a general serial port can be used.

The serial data is stored in a parallel form in the corresponding address of the register 220 of the interface chip 200. If the first input/output port 230 is set as an output port and the second input/output port 240 is set as an input port, the parallel data stored in the register 220 is outputted to the key input unit 300 through each output pin (I/O₀-I/O₇) of the first input/output port 230.

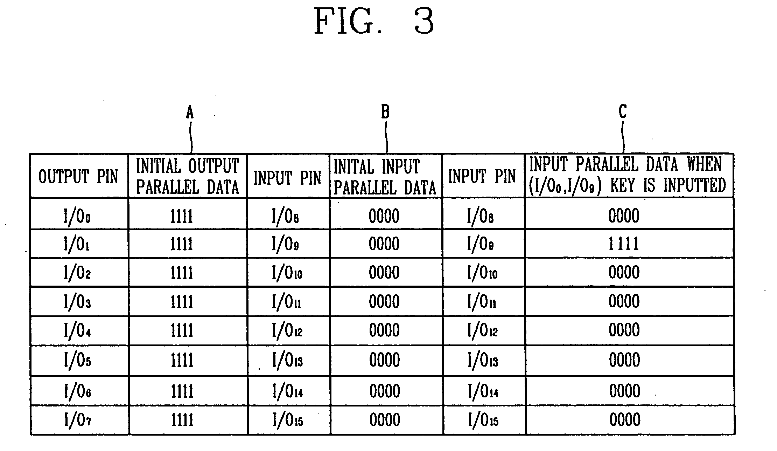

For example, as shown in Figure 3, it is assumed that data 1111 is simultaneously outputted through each output pin (I/O₀-I/O₇) of the first input/output port 230 (A) and each input pin (I/O₈-I/O₁₅) of the second input/output port 240 has data 0000 (B).

When a corresponding key is inputted by a user of the key input unit 300, a corresponding output pin of the first input/output port 230 connected to the inputted key and a corresponding input pin of the second input/output port 240. Accordingly, a signal of the corresponding output pin is inputted to the corresponding input and the signal of the input pin is changed, according to which the first transistor 250 output an interrupt signal.

For example, as shown in Figure 3, when a key for connecting the first output pin (I/O₀) and the second input pin (I/O₉) is inputted by a user, the first output pin (I/O₀) and the second input pin (I/O₉) are connected so that the data 1111 of the first output pin (I/O₀) is inputted to the second input pin (I/O₉) and data of the remaining output pins (I/O₁-I/O₇) is not inputted to the corresponding input pins (I/O₈,I/O₁₀-I/O₁₅). Thus, parallel data as shown in (C) of figure 3 is received by the second input/output port 240 and an interrupt signal is generated according to the change of the received parallel data. The signals inputted to each input pin (I/O₈-I/O₁₅), namely the parallel data (C) of Figure 3, are store dint he register 220 of the interface chip 200.

The controller 100 accesses the register 220 of the interface chip 200 through the address line pins 101-103 and reads the inputted parallel data (C) through the serial port 105.

The controller 100, which stores previous parallel data (B) of each input pin (I/O₈-I/O₁₅) of the second input/output port 240, compares the previous parallel data (B) and the currently read parallel data (C) and checks, an input pin corresponding to the changed data, namely, a second input pin (I/O₉).

And then, in order to check an output pin corresponding to the input key, the controller 100 changes the output data of each output pin (I/O₀-I/O₇) in turn and sequentially transmits eight serial data sequence to the register 220 of the interface chip 200 according to the certain serial communication method.

Then, the interface chip 200 converts each serial data sequence to each parallel data through the register 220 and outputs it to the first input/output port 230, and each outputted parallel data is inputted to the register 220 through the key input unit 300 and the second input/output port 240. And the controller 100 accesses the register 220 and sequentially reads each inputted parallel data according to the certain serial communication method.

Thereafter, the controller 100 checks whether the data corresponding to the checked input pin (the second input pin (1/O₉)) in the serial data sequence has been changed, which is sequentially performed on each serial data sequence.

Namely, after the controller 100 outputs the first serial data sequence obtained by changing the output data of the first output pin (I/O₀) to the interface chip 200, when the first serial data sequence is converted into parallel data and then inputted to the register 220 through the first input/output port 230, the key input unit 300 and the second input/output port, the controller 100 accesses the register 220 and reads the parallel data according to the certain serial communication method and checks whether data corresponding to the checked input pin (corresponding to the second input pin (I/O₉)) in the read serial data sequence has been changed.

When the data corresponding to the second input pin (I/O₉) has been changed, the controller 100 determines that the first output pin I/O₀ is connected to the inputted key.

If, however, the data corresponding to the second input pin (I/O₉) has not been changed, the controller outputs the second serial data sequence obtained by changing the output data of the second output pin (I/O₁) to the interface chip 200 and checks whether the second output pin (I/O₁) has been connected to the inputted key.

In this manner, the controller 100 sequentially checks eight serial data sequences obtained by changing output data of each output pin (I/O₀-I/O₇) of the first input/output port 230.

Accordingly, the controller 100 searches an input pin connected to the inputted key, changes a value of each output pin of the interface chip 200 in turn and outputs it, and then, checks an output pin for changing data of the searched input pin, thereby searching an inputted key of the key combination of the 8x8 matrix.

Thus, because the controller can receive a key of the key input unit by using the address line pin, the serial data line pin and the interrupt pin, it can control a large number of input keys with a small number of controller pins.

As so far described, the apparatus and method for controlling keys of a mobile terminal of the present invention have the following advantages.

That is, for example, the interface chip for performing conversion between parallel data and serial data of the key input unit is provided between the controller and the key input unit, and the controller can control the key input unit having large number of keys with a small number of pins by using three pins of an address line for reading and writing the register of the interface chip, two pins for giving and receiving the serial data to and from the interface chip and one pin for receiving an interrupt from the interface chip.

In addition, because the small number of controller pins is used to control the large number of input keys, it is easy to design a mobile terminal.

Moreover, the present invention can be applied for inputting a large number of keys required for a chatting phone which is expected to be increased in use in the future.

The foregoing embodiments and advantages are merely exemplary and are not to be construed as limiting the present invention. The present teaching can be readily applied to other types of apparatuses. The description of the present invention is intended to be illustrative, and not to limit the scope of the claims. Many alternatives, modifications, and variations will be apparent to those skilled in the art. In the claims, means-plus-function clauses are intended to cover the structure described herein as performing the recited function and not only structural equivalents but also equivalent structures.

## Claims

1. Apparatus for controlling keys of a mobile terminal comprising:
an interface chip for performing conversion between parallel data and serial data and generating an interrupt when a key is inputted;
a key input unit for connecting an output port and an input port of the interface chip in order to input a key inputted from a user to the interface chip; and
a controller for recognizing the inputted key of the key input unit by using a certain number of address pins for accessing a register of the interface chip, a certain number of data pins for receiving and transmitting the serial data from and to the interface chip in a certain communication method, and an interrupt pin for receiving the interrupt.

2. The apparatus of claim 1, wherein the interface chip comprises:
a register for storing the serial data transmitted from the controller as parallel data according to an address outputted from the controller, and reversely, converting the parallel data into serial data under the control of the controller;
first and second input/output ports connected between the key input unit and the register and inputting/outputting certain bits of parallel data; and
a first transistor for generating the interrupt when a key is inputted to one of the first and second input/output ports from the key input unit.

3. The apparatus of claim 2, wherein when one of the first and second input/output ports is set as an output port, the other is set as an input port.

4. The apparatus of claim 2, further comprises:
an input filter for filtering the serial data transmitted from the controller according to the certain communication method and transmitting it to the register;
a second transistor for transmitting the serial data read from the register to the controller; and
a power controller for turning on/off power of the interface chip or resetting the interface chip.

5. The apparatus of claim 4, wherein the certain communication method includes 12C (or IIC (Inter Integrated Circuit)) method, a micro-WIRE method and a general serial communication method.

6. The apparatus of claim 1, wherein when the interrupt is inputted to the interrupt pin, the controller accesses the register of the interface chip through the address pin, reads parallel data, which has been inputted to the register through the input port according to the key inputted to the key input unit, through the data pin, compares the read serial data with previously stored serial data, to thereby search an input pin connected to the inputted key.

7. The apparatus of claim 6, wherein the controller searches an output pin connected to the inputted key by outputting serial data sequence obtained by changing in turn data of each output pin of the output port of the interface chip, inputting each serial data sequence to each input pin of the input port of the interface chip through the key input unit, reading the parallel data stored in the register through the data pin according to a certain serial communication method, and checking a serial data sequence which has changed data of the searched input pin.

8. The apparatus of claim 1, wherein the number of address pins is 3, the number of data pins is 1 or 2 according to the certain serial communication method, and the number of interrupt pin is 1.

9. A method for controlling keys of a mobile terminal having a controller, an interface chip and a key input unit, comprising:
a step in which when an interrupt is received from an interface chip to an interrupt pin of the controller, the controller senses key inputting of the key input unit;
a step in which when the key inputting is sensed, the controller reads serial data from the interface chip through a serial communication data pin;
a step in which the controller compares the read serial data with previously stored serial data and searches an input pin of the interface chip connected to the key; and
a step in which the controller sequentially outputs a plurality of serial data sequence obtained by changing in turn data of each output pin of the interface chip, to the interface chip through the serial communication data pin in order to search an output pin of the interface chip connected to the key.

10. The method of claim 9, wherein the interrupt is outputted by the interface chip when a key is inputted to the key input unit.

11. The method of claim 9, further comprising:
a step in which the controller outputs initialization serial data through the serial communication data pin and an address through an address pin to the interface chip; and
a step in which the interface chip stores the initialization serial data as parallel data in a register region corresponding to the address and outputs the initialization parallel data to the key input unit through an output port.

12. The method of claim 9, wherein the step of sensing key inputting comprises:
a step in which when a key is inputted from outside, the key input unit connects an output pin of the interface chip corresponding to the inputted key and an input pin of the interface chip to update input parallel data of the input pins of the interface chip; and
a step in which when the input parallel data is updated, the interface chip outputs the interrupt to the interrupt pin of the controller.

13. The method of claim 9, wherein the step of performing the procedure of searching an output pin of the interface chip comprises:
a step in which the controller transmits a plurality of serial data sequences obtained by changing in turn data of each output pin of the interface chip, to the interface chip one by one;
a step in which the controller sequentially reads each input parallel data of input pins of the interface chip with respect to each serial data sequence transmitted to the interface chip, through the serial communication data pin; and
a step in which the controller checks an input serial data sequence which has changed data of the searched input pin among input serial data sequences read through the serial communication data pin, and searches an output pin connected to the inputted key.

14. The method of claim 13, wherein each input parallel data with respect to each serial data sequence indicates parallel data of input pins of the input port of the interface chip connected to the key input unit when each serial data sequence is outputted in a parallel form to the key input unit through output pins of the output port of the interface chip.

15. The method of claim 9, wherein the serial communication data pin includes a 12C (or IIC (Inter Integrated Circuit)) method pin, a micro-WIRE method pin and a general serial communication method pin.
